# EUROPEAN PATENT SPECIFICATION

(11) **EP 0 855 726 B1**
(45) Date of publication and mention of the grant of the patent: **25.01.2006**
(21) Application number: 97810033.7
(22) Date of filing: 22.01.1997
(51) Int. Cl.: H01G 9/20

(54) **Solar cell and process of making same**
Sonnenzelle und Verfahren für seine Herstellung
Cellule solaire et procédé de fabrication

(43) Date of publication of application: 29.07.1998
(73) Proprietor: Greatcell Solar S.A., 1007 Lausanne (CH)
(72) Inventor: Desilvestro, Hans, 1462 Yvonand (CH); Azam, Asef, 1510 Moudon (CH); Petterson, Henrik, 1004 Lausanne (CH)
(74) Representative: BOVARD AG

(56) References cited:
- EP-A- 0 058 995
- DE-A- 4 218 327
- DE-A- 4 416 247

## Description

### TECHNICAL FIELD

The present invention concerns a solar cell, based on the sensitization of a large band gap semiconductor, using an electrolyte medium with a redox mediator in order to convert solar radiation or indoor light to electricity. More particularly, the invention concerns a solar cell with unlimited freedom for the appearance design of said solar cell, in terms of two-dimensional patterning and coloration while maintaining its functionality for light to electricity conversion.

### BACKGROUND OF THE INVENTION

Photoelectrochemical regenerative cells, based on sensitization of a semiconductor, have been known for some time. One of the more promising systems, being based on the sensitization of TiO₂ with a Ru-based chromophores and an electrolyte medium containing the electrochemical couple iodine/iodide as the redox mediator, has been described in O'Regan et al., Nature, Vol. 353, p. 737 (1991). Various aspects of this system have been disclosed previously. U.S. Pat. No. 4,927,721 discloses the utilization of highly porous semiconductor layers being modified by a monomolecular chromophore layer. U.S. Pat. No. 5,084,365 and 5,525,440 describe methods of applying semiconductor layers, e.g. by a sol-gel process, in order to obtain highly porous and efficient semiconductor layers. A promising class of Ru-based chromophores is disclosed in U.S. Pat. No. 5,463,057.

The electrolyte medium 4 can consist of inorganic and/or organic salts being dissolved in organic solvents (type I), inorganic and/or organic salts being incorporated in a polymer matrix (type II), inorganic and/or organic salts or salt mixtures which are liquid by themselves over a large range of temperatures (type III), or of any combination of the three said types. Examples for electrolyte solutions of type I are given in U.S. Pat. No. 5,438,556 and 5,525,440. Polyether-based polymer electrolytes of type II have been described in U.S. Pat. No. 5,438,556 and in T. Yohannes et al., J. Electrochem. Soc., Vol. 143, p. 2310 (1996). N. Papageorgiou et al. provide examples for electrolyte media of type III in J. Electrochem. Soc., Vol. 143, p. 3099 (1996). As an alternative to a classical electrolyte system, a hole conductor can be employed. Such a system, using p-Cul as the hole conductor, has been described in K. Tennakone et al., Semicond. Sci. Technol., Vol. 10, p. 1689 (1995).

US patent No. 5 463 057 discloses that, in a photovoltaic cell, one can use a compound of formula (I): (X).sub.n RuLL.sub.1 where n is 1 or 2, preferably 2, and in which Ru is ruthenium; each X independently is selected from Cl, SCN, H.sub.2 O, Br, I, CN and SeCN and L is a ligand of formulae (a) to (g) and L.sub.1 is selected from a ligand of formulae (a) to (c) where each R independently is selected from OH, hydrogen, C.sub.1-20 alkyl, --OR.sub.a or-N(R.sub.a).sub.2 and each R.sub.a independently is hydrogen or C.sub.1-4 alkyl.

European patent application No. EP 0058 995 discloses an electrochromic display device having an electrochromic layer and a solid proton conductive layer between a transparent electrode and a counter electrode. The main component of the solid proton conductive layer is a mixture of at least one of titanic acid, stannic acid, antimonic acid, zirconic acid, niobic acid, tantalic acid and silicic acid. The response time is shortened, the service life is prolonged, and printing may be adopted for formation of cells.

### SUMMARY OF THE INVENTION

Photoelectrochemical regenerative cells, based on sensitization of a semiconductor, hold the promise to be manufactured at low cost. In contrast to the preparation of standard single crystal, polycrystalline or amorphous silicon photovoltaic cells, relatively simple, non-expensive techniques, such as screen or roller printing, spray painting or dispersion stamping can be used for applying the active layer 1. These methods open entirely new design possibilities for photovoltaic cells for outdoor and indoor applications. In addition, the inherent chemistry involved in photoelectrochemical regenerative cells allows a large variation in the coloration of the active layer, such as purple, blue, green, yellow or red, by selecting appropriate chromophores. A further design parameter of photoelectrochemical regenerative cells consists in the chemical nature of the redox mediator, which can be tuned to display different coloration. In addition, electrochemically inert dyes or pigments can be incorporated in the cell.

The aim of the present invention is to provide a solar cell where the active layer is applied in a distinctive pattern and color, in order to be employed as a stand-alone power source with an additional advertisement, decoration or any other display function for personalized purposes. The pattern can be geometric, figurative, alpha-numeric or any combination thereof. Such devices can be used for supplying electric power to personalized greeting cards playing an appropriate melody, to personalized desk or wall clocks, watches where the solar cell can represent fully of partly the watch's face, pocket calculators, flash lights, or any other display, personalized or advertising item.

Therefore, the present invention relates to a photoelectrochemical regenerative cell of at least one element, comprising
a photoanode consisting of a layer of a large band gap, greater than 2.7 V semiconductor, applied on a substrate in any two-dimensional pattern and creating a colour contrast to the areas where the photoanode is not applied, in order to provide a personalised photovoltaic cell,
a cathode,
an electrolyte medium in between the electrodes,
a sealing structure and
two electric contacts,
at least one of the substrate and the cathode being transparent to visible light,
and is characterised in that
the photoanode is modified by an ultra-thin layer of a chromophore dye absorbing a large fraction of visible light,
the cathode consists of a second substrate,
the electrolyte medium contains a redox mediator and
the zones within the cell which are not covered by the semiconductor layer are free of electrolyte medium.

Further objects will become apparent upon consideration of the detailed description of the preferred embodiments of the present invention.

### BRIEF DESCRIPTION OF THE DRAWINGS

All figures are presented that the preferred direction of the incident light is from above.
FIG. 1 depicts a cross section schematic of a photoelectrochemical regenerative cell in accordance with the present invention.
FIG. 2 depicts a plan view of a single element photoelectrochemical regenerative cell in accordance with the present invention.
FIG. 3 depicts a plan view of the photoanode pattern of a photoelectrochemical regenerative three-element cell in accordance with the present invention.
FIG. 4 depicts a plan view of a three-element photoelectrochemical regenerative cell with appropriate electric interruptions 12 and external series connections 13 in accordance with the present invention.
FIG. 5 depicts a partially exploded, isometric view of a four-element photoelectrochemical regenerative cell with much shorter external series connections 14 than those in FIG. 4.

### DETAILED DESCRIPTION OF THE INVENTION

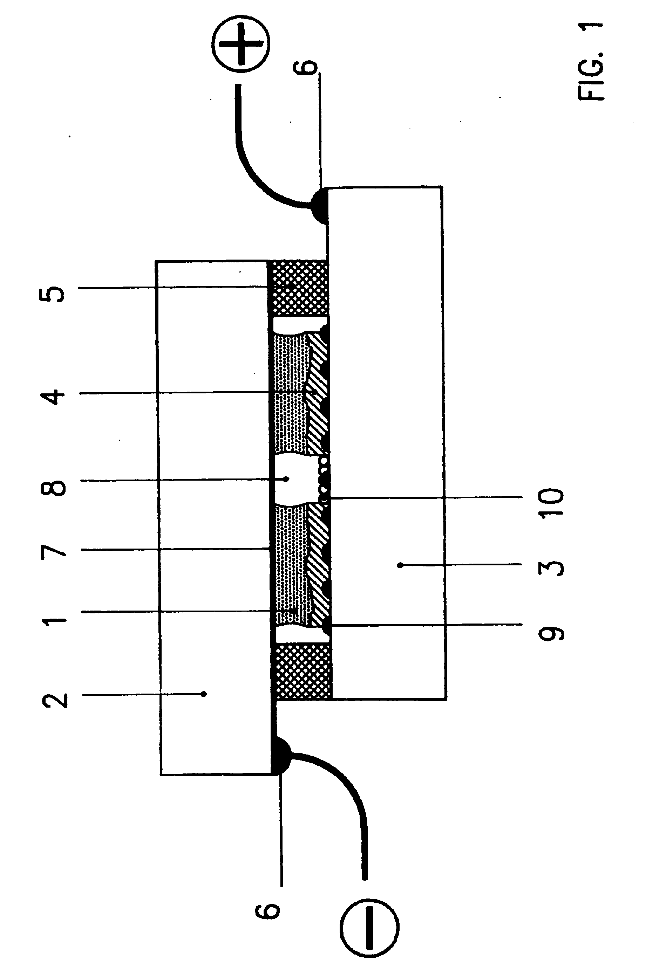

As illustrated in FIG. 1, the photoelectrochemical regenerative cell in accordance with the present invention comprises a substrate 2. In a preferred embodiment, said substrate is transparent to visible light and consists of a glass or polymer sheet, covered on the inner side with a thin electrically conducting layer 7 such as doped tin oxide, zinc oxide or indium oxide/tin oxide (ITO). A layer of semiconductor material 1 is applied on top of the conductive substrate. A preferred semiconductor is TiO₂, prepared from a colloidal suspension, e.g. by a sol-gel process. The colloidal suspension can be applied to the substrate 2 by screen or roller printing, spray painting, dispersion stamping or any other method chosen by persons skilled in the art. Preparation procedures will be described in greater detail hereinafter.

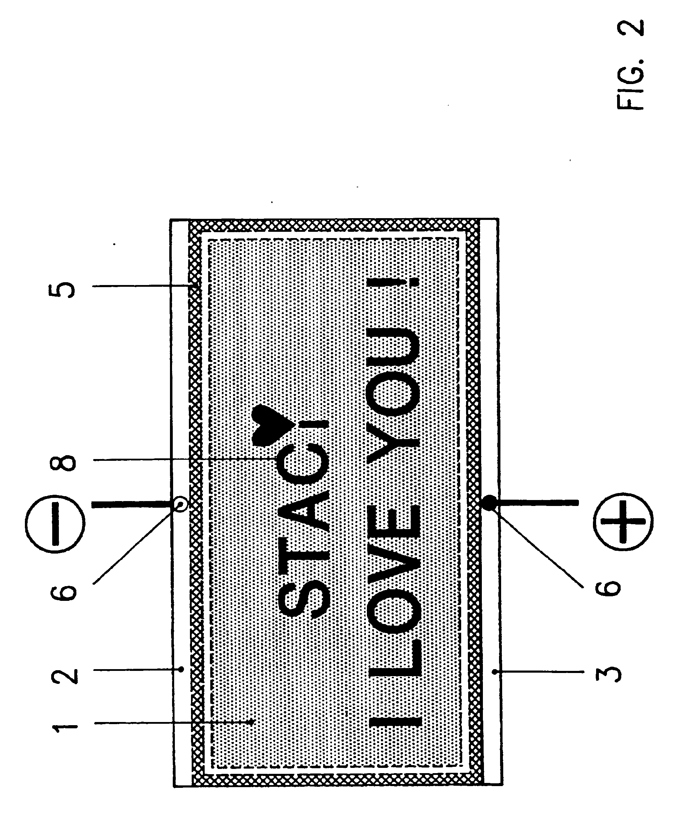

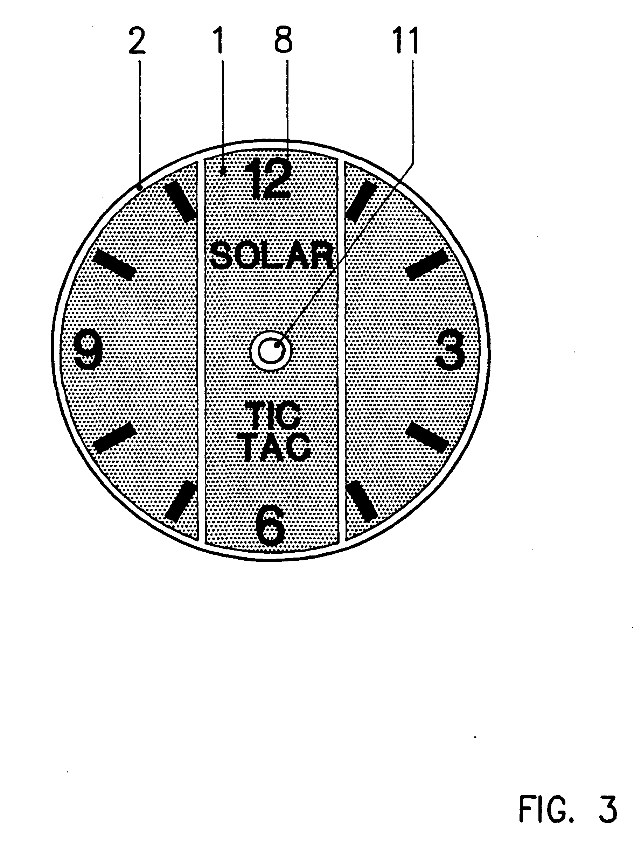

The distinctive feature of the present invention relies on the specific two-dimensional shape the semiconductor layer is printed, sprayed, stamped or otherwise applied. No limits in shape (such as letters, numbers, any figurative or geometric patterns) are given since the corresponding masks for printing, spraying or stamping can be prepared easily, e.g. by standard photolithographic procedures. FIG. 1 depicts, as an illustration, a zone 8 where no semiconductor material has been deposited. FIG. 2 depicts an example of a one-element cell with a specific pattern. FIG. 3 depicts an example of a photoanode pattern of a three-element cell where the solar cell is at the same time the face of a watch or a desk clock. In the case of an analogue watch or clock, a central hole 11 may be required.

After applying the semiconductor layer, said layer is fired in order to pyrolyze any organic stabilizer required for semiconductor colloid stabilization and to sinter the colloid particles, resulting in a highly porous semiconducting layer. In the case of TiO₂, the firing temperature is in the order of 450-500°C. Preferred film thickness for TiO₂ layers is 5-10 µm.

The semiconductor layer 1 is then modified by specifically adsorbing an appropriate chromophore. If high light-to-electricity conversion rates are required preferred chromophores belong to the class of Ru dyes, as described in U.S. Pat. No. 5,463,057. Otherwise, any other chromophore can be chosen, depending on the required color of the photoanode. The dye is applied by impregnation, e.g. by soaking the semiconducting layer 1 in a dye solution containing solvents such as ethanol, butanol, acetonitrile or any other organic solvent allowing for high enough dye concentrations. The dye impregnation is accomplished preferably above room temperature, but below the boiling point of the solvent or the solvent mixture. Thus a patterned photoanode, which is defined by a dye impregnated semiconductor layer on an electrically conductive substrate, is obtained, creating a color contrast to the areas where the photoanode is not applied.

As an alternative, the patterned photoanode can be created by applying the dye or a dye/electrolyte mixture as a relatively viscous paste to the semiconductor layer 1, e.g. by printing or stamping techniques. In a preferred embodiment, the composition and viscosity of such a paste is adjusted that the mean maximum diffusion path of the dye molecules, before adsorption on the electrode surface occurs, corresponds as closely as possible to the thickness of the semiconductor layer 1, in order to obtain an optimum coloration of the photoanode and, at the same time, a high resolution for the pattern.

The cathode consists a second substrate 3. Said substrate may be transparent to visible light and consist of a glass or polymer sheet, covered on the inner side with a thin electrically conducting layer such as doped tin oxide, zinc oxide or indium oxide/tin oxide (ITO). It can be advantageous to deposit an electrocatalytically active material 9 on top of the conductive layer in order to accelerate the redox reaction. In the case of the iodine/iodide mediator system, small amounts of platinum have been shown to be effective as an electrocatalyst. If the photoelectrochemical regenerative cell consists of more than one single element on the same substrate, the electrically conducting layer has to be interrupted as explained hereinafter.

However, the substrate 3 of the cathode can also consist of any electrically conductive bulk material which is chemically compatible with the electrolyte medium 4, such as titanium, carbon materials or carbon filled thermoplastics. In such a case, each element of a multi-element photoelectrochemical cell has to have its individual cathode substrate.

In addition, the cathode substrate 3 can be partially covered by pigment layers 10 forming any two-dimensional pattern of any desired combination of colors. The pigment layers should be chemically compatible with the electrolyte medium. Preferably, said pigment layers are applied onto the cathode substrate 3 below zones 8 which have not been covered by the semiconductor material. As an alternative, said pigment layers can also be applied within zones 8 onto the photoanode substrate 2.

It is obvious that for certain applications, a similar visual impression of a two-dimensional pattern can be obtained, without using a patterned photoanode, by trivial measures such as printing or applying by other means, e.g. by colored adhesive tapes, a two-dimensional pattern on one or two outer surfaces of the solar cell. However such embodiments are considered of no innovative value and do not offer the advantage of indelible and absolutely scratch-proof patterns.

The electrolyte medium 4 consists preferably of a relatively viscous liquid which can be applied onto the semiconductor layer by printing or stamping techniques. In a preferred embodiment, the electrolyte medium does not fill the space between 8 and 10. Electrolytes belong preferably to the types II or III. Preferred electrolytes include organic iodide molten salts with melting points below 0°C, such as described in N. Papageorgiou et al., J. Electrochem. Soc., Vol. 143, p. 3009 (1996). The viscosity and the ion diffusion coefficients can be varied largely by adding various amounts of organic solvents such as nitriles, N-methyloxazolidinone or N-methylpyrrolidinone and/or polymeric or inorganic thickeners such as poly-ethers, poly-siloxanes, poly-acrylonitriles, amine- or amide-substituted polymers (e.g. of the vinyl type) or oxides such as TiO₂, SiO₂, Al₂O₃ or zeolite powder particles.

For special design reasons, however, the space between 8 and 10 can be filled with the electrolyte medium as well. In such a case, the electrolyte medium may be further colored by adding appropriate dyes to said medium. Said dyes have to be compatible with the cell chemistry.

The cells are assembled and sealed by a sealing structure 5, in order to give the embodiment schematically shown in FIG. 1. Preferred sealing materials are silicone glues, epoxy resins, low melting ceramics, and/or gaskets consisting of thermoplastic foils such as fluoropolymers, polyvinylidene chlorides or suitably modified polyolefines. One example for the latter class of compounds is Surlyn ®.

If the photoelectrochemical regenerative cell consists of more than one single element on the same substrate appropriate areas have to be designed where no semiconductor layer is present and where the substrate electrically conductive layer is interrupted in order to enable series connections to be made from element to element. The electric interruptions 12 can be realized by mechanical (e.g. abrasion, sand blasting) or chemical means (etching), by laser ablation or any other method chosen by persons skilled in the art. Said electric interruptions can be prepared either before applying the semiconductor layer 1 or, after having covered practically the whole substrate 2 surface with the semiconductor layer 1, by removing said layer and the electrically conductive layer 7 at the same time by methods such as mechanical abrasion, sand blasting or laser ablation.

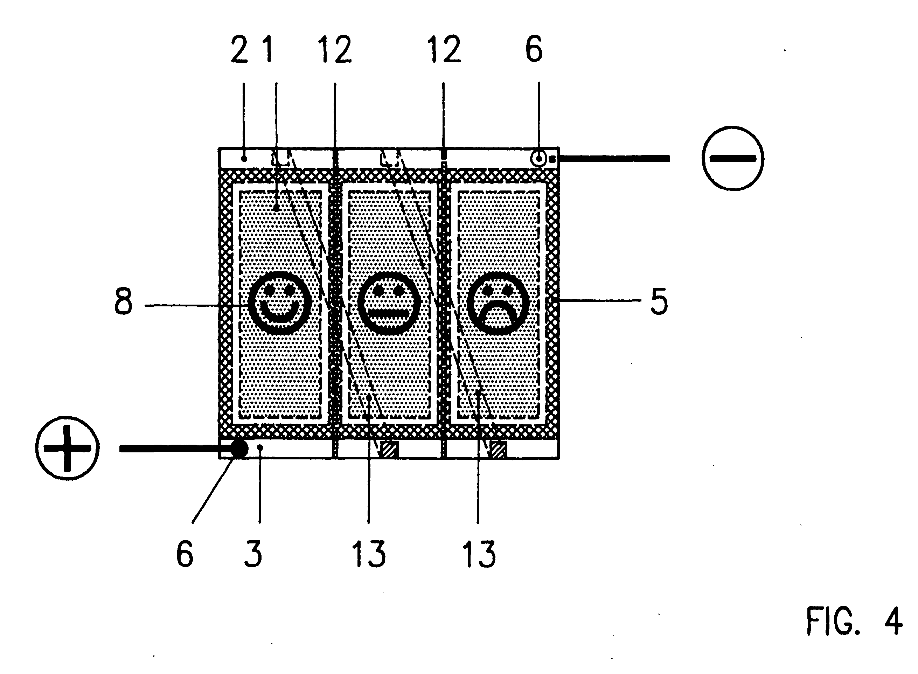

Various possibilities for series-connections in the case of multi-element cells are known to persons skilled in the art. One of the methods has recently been described in A. Kay et al., Solar Energy Materials and Solar Cells, Vol. 44, p. 99 (1996). For indoor applications where the required photocurrents are often in the sub-mA range, the series connections can even be realized externally from cell to cell. One possibility for such external series connections is depicted in FIG. 4. The conductive elements 13 can consist of metal strips or wires which are electrically connected to the conductive sides of substrates 2,3. The stripes can also be printed, painted or sprayed directly onto the conductive and non-conductive surfaces of the cathode sheet 3, by using any electrically conductive paint based on materials such as carbon, silver, copper, gold. External series connections according to FIG. 4 are relatively easy to manufacture, but have the disadvantage of relatively long current paths.

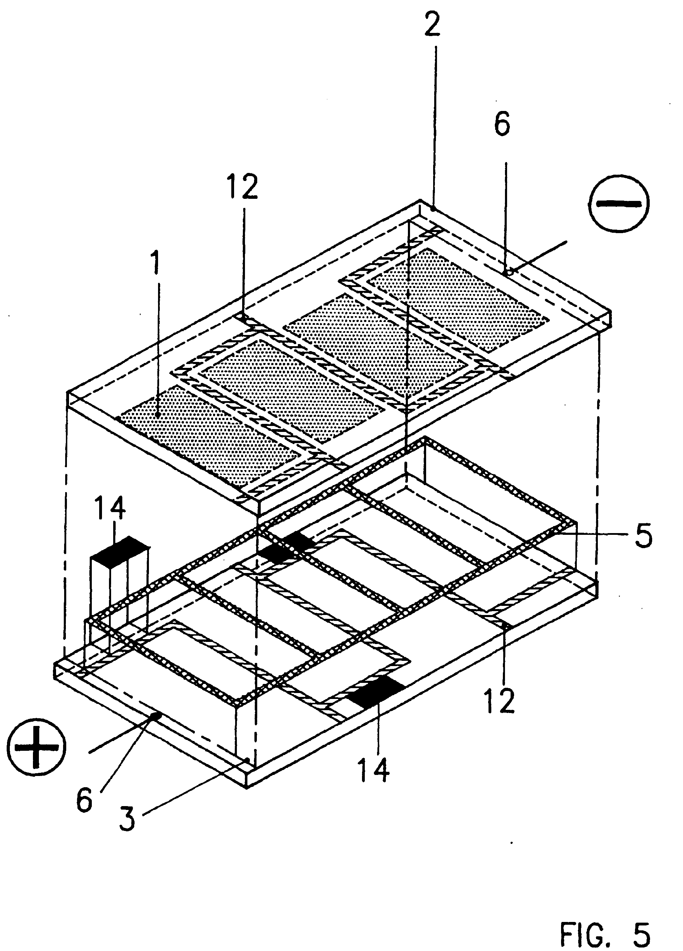

Another possibility for external connections, with shorter current paths is shown in FIG. 5. Thereby, substrates 2 and 3 consist, in a preferred embodiment, of an electronic insulator, which is covered on one side by a thin electrically conductive layer. The series connections are established by contact structures 14 which are printed, painted, sprayed, deposited by a photolithographic/galvanic process or simply established mechanically by placing a thin strip of metal foil onto the conductive side of either substrate 2 or, preferably, substrate 3, outside the sealing structure 5 as shown in FIG. 5. The thickness of the contact structures 14 which is, in a preferred embodiment, in the order of 10-50 µm, defines the distance between substrates 2 and 3 which are held together under slight compression by means of a resin or by a mechanical device. FIG. 5. shows an example for the design of electric interruptions 12 of a four-element cell. It is obvious to persons skilled in the art that other insulating patterns 12 and contact structures 14 can be designed which fulfil the same functions of connecting the elements in series and, at the same time, avoid short circuits. External series connections according to FIG. 5 are superior to connections according to FIG. 4 since the current paths are, in the former case, at least 2-3 orders of magnitude shorter.

An alternative to series connections, in order to obtain the required voltage, is voltage transformation from one single cell by a DC-DC converter. In a preferred embodiment, such a DC-DC converter does not rely on an additional external power source such as a primary or a rechargeable battery or an electrochemical capacitor ("supercapacitor"). Standard electronic semiconductor devices can not be used for such a converter since the supply voltage from the solar cell may be as low as 0.4 V under illumination and still lower in the dark. Such a DC-DC converter consists, in a specific embodiment, of an oscillator stimulated by the solar cell. The resulting AC signal is then amplified to the appropriate voltage by a transistor based on germanium or on SOI technology (semiconductor on insulator) and finally reconverted to DC by standard circuitry.

The invention will now be further illustrated by the following specific

examples.

### EXAMPLE 1

A 30 x 20 mm sheet of SnO₂ coated conducting glass from Libbey-Owens-Ford Co., Ohio, USA, with a sheet resistance of 15 Ω/cm² and a transmittance of ca. 85 % in the visible, is coated with a colloidal titanium dioxide film. The TiO₂ colloid solution is prepared by hydrolysis of titanium tetraisopropoxide (Aldrich), peptisized with tetramethylammonium hydroxide as described by A. Kay et al., Solar Energy Materials and Solar Cells, Vol. 44, p. 99 (1996). After hydrothermal treatment in an autoclave at 230°C for 6 hours, water is evaporated to obtain a concentration of 2 g TiO₂ per liter. The suspension is centrifuged in order to remove water and the basic solution. The TiO₂ slurry is then rinsed twice with dry ethanol. 40 parts (by weight) of this slurry are mixed with 60 parts of anhydrous terpineol (Fluka) and then treated in an ultrasonic bath for 15 min. Finally, 1 % by weight of ethyl cellulose (Ethocel ®, 45 mPa s for 5% in toluene/ethanol, 80/20, v/v, 20°C) is added. The TiO₂ paste is thereafter passed three times trough a three roll mixer.

The TiO₂ film 1 is applied by screen printing the logo of the Leclanché company onto the photoanode substrate 2. The projected TiO₂ surface corresponds to ca. 2 cm². After sintering under air at 500°C for 30 minutes and cooling down, the performance of the film as a photoanode is improved by further deposition of a small quantity of TiO₂ from an aqueous TiCI₄ solution as described by M.K. Nazeeruddin et al., J. Am. Chem. Soc., Vol. 115, p. 6382 (1993). The film is sintered once more under air at 500°C for 30 minutes. The final thickness of the TiO₂ layer is ca. 10 µm.

The TiO₂ coated electrode is then immersed into a 3 x 10⁻⁴ M solution of cis-di(thiocyanato)-N,N-bis(2,2'-bipyridyl-4,4'-dicarboxylic acid)-ruthenium (II) dihydrate, prepared according to the procedure described in U.S. Pat. No. 5,463,057, in a mixture of absolute ethanol and 4-tert-butanol (50/50, v/v) for 3 hours at 60°C. The electrode is thereafter treated by a solution of 0.3 M 4-tert-butyl-pyridine (Fluka) in dry ethanol for 10 min. and then dried under a stream of dry nitrogen.

The electrolyte medium 4 is prepared by mixing 1,3-hexyl-methylimidazolium iodide, described by N Papageorgiou et al., J. Electrochem. Soc., Vol 143, p. 3099 (1996) and polyethylene oxide (Union Carbide) (75/25, w/w) and then adding 7 x 10⁻³ M l₂ and 0.3 M 4-tert-butyl-pyridine (Fluka). This electrolyte is applied onto the dye coated TiO₂ film by screen printing, using a screen with the same pattern as for TiO₂ deposition.

For the cathode, a 30 x 20 mm sheet of conducting SnO₂ coated glass from Libbey-Owens-Ford Co., Ohio, USA, with a sheet resistance of 15 Ω/cm² and a transmittance of ca. 85 % in the visible is used. A thin layer 9 of platinum of less than 3 mg/cm² is thermally deposited on the glass sheet according to the technique described by N. Papageorgiou et al., accepted for publication in J. Electrochem. Soc., MS 96-03-053.

The cathode is placed on top of the dye coated TiO₂ film whose pores are filled with the electrolyte medium 4 described hereinabove. Thereby the cathode substrate 3 covers the photoanode substrate 2 only over ca. 17.5 mm, leaving two areas of each 30 x ca. 2.5 mm where the electric contacts 6 can be affixed according to FIG. 2. The two glass pieces are sealed together with Silastic 744 (Dow Coming), followed by a second seal of Torrseal (Varian). Finally, 2 electric contacts are applied using commercial silver epoxy.

In this way, a solar cell is obtained which yields, under illumination by a 60 W incandescent lamp at a light intensity of 100 Lux, a short circuit current of 30 µA (15 µA/cm², based on the area of the photoanode) and an open circuit voltage of 490 mV.

### EXAMPLE 2

With the exception of the electrolyte medium 4, all cell components are the same and the cells are mounted in the same way as in Example 1. The composition of the electrolyte is a mixture of glutaronitrile and polyethylene oxide (Union Carbide) (50/50, w/w) to which 0.05 M tetrabutylammonium iodide, 0.01 M l₂ and 0.1 M 4-tert-butyl-pyridine are added. This electrolyte is applied onto the dye coated TiO₂ film by screen printing, using a screen with the same pattern as for TiO₂ deposition.

In this way, a solar cell is obtained which yields, under illumination by a 60 W incandescent lamp at a light intensity of 100 Lux, a short circuit current of 34 µA (17 µA/cm², based on the area of the photoanode) and an open circuit voltage of 535 mV.

## Claims

1. A photoelectrochemical regenerative cell of at least one element, comprising
a photoanode consisting of a layer of a large band gap, greater than 2.7 V semiconductor (1), applied on a substrate (2) in any two-dimensional pattern and creating a colour contrast to the areas where the photoanode is not applied, in order to provide a personalised photovoltaic cell,
a cathode (3),
an electrolyte medium (4) in between the electrodes,
a sealing structure (5) and
two electric contacts (6),
at least one of the substrate (2) and the cathode (3) being transparent to visible light,
**characterised in that**
the photoanode is modified by an ultra-thin layer of a chromophore dye, absorbing a large fraction of visible light,
the cathode (3) consists of a second substrate,
the electrolyte medium (4) contains a redox mediator and
the zones (8) within the cell which are not covered by the semiconductor layer are free of electrolyte medium.

2. A photoelectrochemical regenerative cell according to claim 1, wherein the semiconductor layer (1) is deposited as a two-dimensional pattern on the substrate (2) by screen or roller printing, spray painting or dispersion stamping.

3. A photoelectrochemical regenerative cell according to one of the preceding claims, wherein the electrolyte medium (4) is deposited on the semiconductor layer (1) by screen or roller printing, spray painting or dispersion stamping.

4. A photoelectrochemical regenerative cell according to one of the preceding claims, wherein several elements are mounted using one single substrate (2) and one single substrate (3) and are connected in series by contact structures (14), allowing for shortest possible external current paths.

5. A photoelectrochemical regenerative cell according to one of the preceding claims, wherein the voltage of one single element is transformed by a DC-DC converter consisting of an oscillator, a transistor based on germanium or on SOI technology and a standard AC-DC converter.

6. A photoelectrochemical regenerative cell according to one of the preceding claims, wherein substrate (2) is transparent and covered by a thin electrically conductive film (7).

7. A photoelectrochemical regenerative cell according to one of the preceding claims, wherein the zones opposite to those which are not covered by a semiconductor layer are fully or partially covered by pigment layers (10) of one or several colors.

8. A photoelectrochemical regenerative cell according to one of the preceding claims, wherein the zones (8) within the cell which are not covered by a semiconductor layer are filled by the electrolyte medium (4) which contains in addition dissolved or suspended coloring agents.

9. A photoelectrochemical regenerative cell according to one of the preceding claims, wherein the patterned photoanode is created by applying one or several pastes containing one or several chromophores onto the semiconductor film (1).

10. A photoelectrochemical regenerative cell according to one of the preceding claims, wherein the semiconductor layer (1) consists of a porous TiO₂ film.

11. A photoelectrochemical regenerative cell according to one of the preceding claims, wherein the electrolyte medium (4) is based on N-substituted heteroaromatic iodide salts which are liquid down to 0°C.

12. A photoelectrochemical regenerative cell according to claim 11, wherein the electrolyte medium (4) is based on 1,2,3-substituted imidazolium iodides.

13. A photoelectrochemical regenerative cell according to one of the preceding claims, wherein the electrolyte medium (4) is gellified or partially solidified by one or several compounds selected from the group of poly-ethers, poly-siloxanes, poly-acrylonitriles, amine- or amide-substituted vinylic polymers, TiO₂, SiO₂, Al₂O₃, zeolite powder particles, nitriles, N-methyloxazolidinone, N-methylpyrrolidinone.

14. A photoelectrochemical regenerative cell according to one of the preceding claims, wherein the redox mediator consists of the system iodine/iodide.

15. A photoelectrochemical regenerative cell according to one of the preceding claims, wherein the chromophore is based on a metallorganic Ru complex containing substituted bipyridine ligands.

16. A photoelectrochemical regenerative cell according to one of the preceding claims, wherein the sealing structure comprises epoxy resins, silicon glues, ceramics and/or gaskets consisting of thermoplastic foils such as fluoropolymers, polyvinylidene chlorides or modified polyolefines.

## Revendications

1. Une cellule photo-électrochimique régénérable ayant au moins un élément, comprenant:
une photo-anode constituée d'une couche d'un semi-conducteur (1) à bande interdite large, supérieure à 2,7 V, appliquée sur un substrat (2) suivant un motif bidimensionnel et créant un contraste de couleurs avec les zones où la photo-anode n'est pas appliquée, afin de réaliser une cellule photovoltaïque personnalisée,
une cathode (3),
un milieu électrolytique (4) entre les électrodes,
une structure d'étanchéisation (5) et
deux contacts électriques (6),
au moins l'un du substrat (2) et de la cathode (3) étant perméable à la lumière visible,
**caractérisée en ce que**
la photo-anode est modifiée par une couche ultra-fine d'un colorant chromophore absorbant une fraction importante de la lumière visible,
la cathode (3) est constituée d'un second substrat,
le milieu électrolytique (4) contient un médiateur rédox et
les zones (8) de la cellule qui ne sont pas recouvertes par la couche de semi-conducteur sont exemptes de milieu électrolytique.

2. Une cellule photo-électrochimique régénérable selon la revendication 1, dans laquelle la couche de semi-conducteur (1) est déposée sous forme de motif bidimensionnel sur le substrat (2) par sérigraphie ou impression au rouleau, impression par pulvérisation ou estampage par dispersion.

3. Une cellule photo-électrochimique régénérable selon l'une des revendications précédentes, dans laquelle le milieu électrolytique (4) est déposé sur la couche de semi-conducteur (1) par sérigraphie ou impression au rouleau, ou estampage par dispersion.

4. Une cellule photo-électrochimique régénérable selon l'une des revendications précédentes, dans laquelle plusieurs éléments sont montés en utilisant un seul substrat (2) et un seul substrat (3) et sont reliés en série par des structures de contact (14), en tenant compte des chemins de courants externes les plus courts possibles.

5. Une cellule photo-électrochimique régénérable selon l'une des revendications précédentes, dans laquelle la tension d'un seul élément est transformée par convertisseur c.c.-c.c. constitué d'un oscillateur, d'un transistor à base de germanium ou basé sur la technologie silicium sur isolant (SOI) et un convertisseur c.a.-c.c.

6. Une cellule photo-électrochimique régénérable selon l'une des revendications précédentes, dans laquelle le substrat (2) est transparent et recouvert d'un film mince électriquement conducteur.

7. Une cellule photo-électrochimique régénérable selon l'une des revendications précédentes, dans laquelle les zones opposées à celles qui ne sont pas couvertes par une couche semi-conducteur sont totalement ou partiellement recouvertes par des couches de pigment (10) d'une ou de plusieurs couleurs.

8. Une cellule photo-électrochimique régénérable selon l'une des revendications précédentes, dans laquelle les zones (8) de la cellule qui ne sont pas couvertes par une couche de semi-conducteur sont remplies par le milieu électrolytique (4) qui contient en outre des agents colorants dissous ou en suspension.

9. Une cellule photo-électrochimique régénérable selon l'une des revendications précédentes, dans laquelle la photo-anode à motifs est créée en appliquant une ou plusieurs pâtes contenant un ou plusieurs chromophores sur le film semi-conducteur (1).

10. Une cellule photo-électrochimique régénérable selon l'une des revendications précédentes, dans laquelle la couche de semi-conducteur (1) est constituée d'un film de TiO₂ poreux.

11. Une cellule photo-électrochimique régénérable selon l'une des revendications précédentes, dans laquelle le milieu électrolytique (4) est à base d'iodures d'hétéroaromatiques N-substitués (sels) qui sont liquides à partir de 0°C.

12. Une cellule photo-électrochimique régénérable selon la revendication 11, dans laquelle le milieu électrolytique (4) est à base d'iodures d'imidazolium 1,2,3-substitué.

13. Une cellule photo-électrochimique régénérable selon l'une des revendications précédentes, dans laquelle le milieu électrolytique (4) est gélifié ou partiellement solidifié par un ou plusieurs composés choisis dans le groupe constitué par les polyéthers, les polysiloxanes, les polyacrylonitriles, les polymères vinyliques substitués par des amines ou des amides, TiO₂, SiO₂, Al₂O₃, les particules de poudre de zéolithe, les nitriles, la N-méthyloxazolidinone, la N-méthylpyrrolidinone.

14. Une cellule photo-électrochimique régénérable selon l'une des revendications précédentes, dans laquelle le médiateur rédox est constitué du système iode/iodure.

15. Une cellule photo-électrochimique régénérable selon l'une des revendications précédentes, dans laquelle le chromophore est à base d'un complexe organométallique du Ru contenant des ligands bypiridine substitués.

16. Une cellule photo-électrochimique régénérable selon l'une des revendications précédentes, dans laquelle la structure d'étanchéisation comprend des résines époxy, des colles à base de silicium, des céramiques et/ou des joints constitués de feuilles de thermoplastiques tels que les fluoropolymères, les chlorures de polyvinylidène, ou les polyoléfines modifiées.

## Patentansprüche

1. Photoelektrochemisch regenerative Zelle mit mindestens einem Element, umfassend
eine Photoanode, die aus einer Schicht eines breitbandigen grösseren als 2,7 V Bandhalbleiters (1) besteht, die an einem Substrat (2) in einem beliebigen zweidimensionalen Muster angebracht wird und wobei ein Farbkontrast zu den Bereichen geschaffen wird, wo die Photoanode nicht angebracht wird, um eine photovoltaische personalisierte Zelle zu erzeugen,
eine Kathode (3),
ein Elektrolytenmedium (4) zwischen den Elektroden,
eine Versiegelungsstruktur (5) und
zwei elektrische Kontakte (6),
wobei mindestens das Substrat (2) oder die Kathode (3) für sichtbares Licht durchsichtig ist,
**dadurch gekennzeichnet,**
**dass** die Photoanode durch eine ultradünne Schicht eines chromophoren Farbstoffes modifiziert ist, welche einen grossen Teil des sichtbaren Lichtes absorbiert,
**dass** die Kathode (3) aus einem zweiten Substrat besteht,
**dass** das Elektrolytenmedium (4) einen Redox-Vermittler umfasst und die Bereiche (8) innerhalb der Zelle, die von der Halbleiterschicht nicht abgedeckt sind, frei vom Elektrolytenmedium sind.

2. Photoelektrochemisch regenerative Zelle nach Anspruch 1, wobei die Halbleiterschicht (1) als zweidimensionales Muster auf das Substrat (2) durch Sieb- oder Tiefdruck, durch Spritzen oder Zerstreueungsprägung aufgebracht wird.

3. Photoelektrochemisch regenerative Zelle nach einem der vorhergehenden Ansprüche, wobei das Elektrolytenmedium (4) auf die Halbleiterschicht (1) durch Sieb- oder Tiefdruck, durch Spritzen oder Zerstreungsprägung aufgebracht wird.

4. Photoelektrochemisch regenerative Zelle nach einem der vorhergehenden Ansprüche, wobei mehrere Elemente durch Verwendung eines einzigen Substrats (2) und eines einzigen Substrats (3) montiert und in Serie durch Kontaktstrukturen (14) verbunden sind, wobei für möglichst kurze externe Stromdurchführungen gesorgt wird.

5. Photoelektrochemisch regenerative Zelle nach einem der vorhergehenden Ansprüche, wobei die Spannung eines einzigen Elements durch einen DC-DC Wandler umgewandelt wird, der aus einen Oszillator, einem Germanium- oder auf SOI-Technologie basiertem Transistor und aus einem AC-DC-Wandler besteht.

6. Photoelektrochemisch regenerative Zelle nach einem der vorhergehenden Ansprüche, wobei das Substrat (2) durchsichtig und mit einer stromleitenden Dünnschicht (7) beschichtet ist.

7. Photoelektrochemisch regenerative Zelle nach einem der vorhergehenden Ansprüche, wobei die Bereiche, die den Bereichen gegenüberliegen, die mit einer halbleitenden Schicht nicht beschichtet sind, durch ein- oder mehrfarbige Pigmentschichten (10) ganz oder teilweise abgedeckt sind.

8. Photoelektrochemisch regenerative Zelle nach einem der vorhergehenden Ansprüche, wobei die Bereiche (8), die mit einer halbleitenden Schicht nicht beschichtet sind, mit dem Elektrolytenmedium (4) gefüllt werden, das zusätzlich gelöste oder suspendierte Farbagente enthält.

9. Photoelektrochemisch regenerative Zelle nach einem der vorhergehenden Ansprüche, wobei die gemusterte Photoanode durch Anbringung einer oder mehreren Pasten auf der halbleitenden Schicht (1)gebildet wird, die ein oder mehrere Chromophore enthalten.

10. Photoelektrochemisch regenerative Zelle nach einem der vorhergehenden Ansprüche, wobei die halbleitende Schicht (1) aus einer porösen TiO₂ Folie besteht.

11. Photoelektrochemisch regenerative Zelle nach einem der vorhergehenden Ansprüche, wobei das Elektrolytenmedium (4) auf N-substituiertem heteroaromatischen Jodidsalzen basiert ist, die bis 0°C flüssig sind.

12. Photoelektrochemisch regenerative Zelle nach Anspruch 11, wobei das Elektrolytenmedium (4) auf 1-2-3 substituierten Imidazolium-Jodiden basiert ist.

13. Photoelektrochemisch regenerative Zelle nach einem der vorhergehenden Ansprüche, wobei das Elektrolytenmedium (4) geliert oder teilweise durch ein oder mehrere Komponente verfestigt wird, die aus der Gruppe von Poly-Etheren, Polysiloxynanen, Polyacrylonitrilen, amino- oder amidesubstituierten vinylischen Polymeren, TiO₂, SiO₂, Al₂O₃, Zeolithpulverpartikeln, Nitrilen, N-Methyloxazolidinonen, N-Methylpyrrolidinonen gewählt werden.

14. Photoelektrochemisch regenerative Zelle nach einem der vorhergehenden Ansprüche, wobei der Redox-Vermittler aus dem Jodinen/Jodiden-System besteht.

15. Photoelektrochemisch regenerative Zelle nach einem der vorhergehenden Ansprüche, wobei das Chromophor auf einem metallorganischen Ru-Komplex basiert, der substituierte Bipyridine-Ligande enthält.

16. Photoelektrochemisch regenerative Zelle nach einem der vorhergehenden Ansprüche, wobei die Versiegelungsstruktur Epoxy-Harz, Silikonklebstoffe, Keramiken und/oder Dichtungen umfasst, die aus thermoplastischen Folien wie Fluoropolymeren, Polyvinylidenen Chloriden oder modifizierten Polyolefinen bestehen.
